# EUROPÄISCHE PATENTSCHRIFT

(11) **EP 2 240 004 B1**
(45) Veröffentlichungstag und Bekanntmachung des Hinweises auf die Patenterteilung: **07.12.2011**
(21) Anmeldenummer: 10400015.3
(22) Anmeldetag: 02.03.2010
(51) Int. Cl.: H05K 3/00

(54) **Montagehilfe für Leiterplattensteckverbinder**
Mounting aid for circuit board connector
Aide au montage pour connecteur enfichable de cartes de circuits imprimés

(30) Priorität: 14.03.2009 DE 202009003648 U
(43) Veröffentlichungstag der Anmeldung: 13.10.2010
(73) Patentinhaber: Harting Electronics GmbH & Co. KG, 32339 Espelkamp (DE)
(72) Erfinder: Pape Günter, 32130 Enger (DE); Schütz, Christian, 32479 Hille (DE)

(56) Entgegenhaltungen:
- US-A- 5 927 504
- DATABASE WPI Week 200950 Thomson Scientific, London, GB; AN 2009-L93609 XP002594957 & CN 201 271 793 Y (WEICHUANGLI SHANGHAI SCI&TECHNOLOGY CO LTD) 15. Juli 2009 (2009-07-15)

## Beschreibung

Die Erfindung betrifft eine Montagehilfe für Leiterplattensteckverbinder zur Aufnahme und Aneinanderreihung von mindestens einem auf einer Leiterkarte zu positionierenden Leiterplattensteckverbinder.

Eine derartige Montagehilfe wird benötigt, um vorzugsweise mehrere Leiterkartensteckverbinder, auch mit unterschiedlichen Abmaßen, gemeinsam auf einer Leiterplatte positionieren zu können, wobei die Montagehilfe nach dem Lötvorgang wieder entfernbar ist.

### Stand der Technik

Derartige Montagerahmen sind durchaus bekannt, haben jedoch den Nachteil, dass sie teilweise nicht entfernbar sind oder nur für spezielle Anordnungen auf einer Leiterplatte konzipiert sind und damit häufig recht kompliziert strukturiert sind.

Aus der US 5,558,540 ist eine Multikontakt-Anordnung bekannt, bei der zwei beabstandet voneinander angeordnete Leiterplattensteckverbinder in einem gemeinsamen Rahmen angeordnet sind, wobei zwischen den beiden Steckverbindern ein entfernbares Halteteil zur Montage der Anordnung angeordnet ist.

### Aufgabenstellung

Der Erfindung liegt daher die Aufgabe zugrunde, eine einfache und günstig herzustellende Montagehilfe zur gemeinsamen Montage von mehreren Leiterplattensteckverbindern auf einer Leiterplatte auszubilden.

Diese Aufgabe wird dadurch gelöst, dass die Montagehilfe einen umlaufenden, rechteckigen Montagerahmen aufweist, bei dem auf zumindest zwei gegenüberliegenden Seiten des Montagerahmens sich kreuzende Tragarme angeformt sind, und dass in zwei weiteren gegenüberliegenden Seiten des Montagerahmens Vorrichtungen zur mindestens zeitweisen Halterung der Leiterplattensteckverbinder vorgesehen sind.

Vorteilhafte Ausgestaltungen der Erfindung sind in den Ansprüchen 2 - 6 angegeben.

Die mit der Erfindung erzielten Vorteile bestehen insbesondere darin, dass mehrere Leiterplattensteckverbinder gleichzeitig in einem Arbeitsgang auf einer Leiterplatte positioniert werden können.
Wobei die Montagehilfe zunächst zur Fixierung der Leiterplattensteckverbinder auf der Leiterplatte verbleibt und erst nach dem Lötgang wieder entfernt wird, so dass ein eventuelles Aufschwemmen der Leiterplattensteckverbinder - insbesondere bei SMD-Bauteilen - strikt verhindert wird.

Desweiteren lässt diese Art der Montage eine Minimierung der Lagetoleranzen zu, da zumindest die gleichzeitig aufgesetzten Leiterplattensteckverbinder eine exakte Ausrichtung auf der Leiterplatte aufweisen und damit eine ebensolche exakte Ausrichtung zu den Gegensteckern gegeben ist. Gleichzeitig werden damit auch mechanische Spannungen zwischen den Steckverbinden vermieden, die eventuell wieder Scherbelastungen und Risse an den Lötstellen hervorrufen, was wiederum zu Ausfällen der Elektronik führen kann.

Einen nicht unwesentlichen Nebenaspekt stellt die Kontrolle von Lötverbindungen zwischen den Kontakten und der Leiterplatte bei der Oberflächenlöttechnik dar.
Leiterplattensteckverbinder in zweireihiger Bauart haben den großen Vorteil, dass die Lötstellen dieser Kontakte auf der Leiterplatte beidseitig des Steckerkörpers visuell überprüfbar sind, während Leiterplattensteckverbinder mit mehr als zwei Steckreihen häufig mit einer wesentlich kostenintensiveren Röntgenuntersuchen getestet werden müssen, um Fehllötstellen an einzelnen Kontakten sicher zu erkennen.
Werden also zweireihige Leiterplattensteckverbinder eingesetzt, so muss eine größere Stückzahl verbaut werden, um eine ähnliche Anzahl an Kontakten auf der Leiterplatte zu kontaktieren. Um deren Montage zu verkürzen und zu Vereinfachen ist der Einsatz der erfindungsgemäßen Montaghilfe durchaus vorteilhaft.

Der Rahmen einer derartigen Montagehilfe ist vorzugsweise zur Aufnahme mehrerer Leiterplattensteckverbinder ausgestaltet, wobei in einer rechteckigen Ausführung auf den gegenüberliegenden Schmalseiten Haltevorrichtungen vorgesehen sind, in denen die Leiterplattensteckverbinder eingeschoben werden und verrastbar sind.
Oberhalb des Steckgesichtes der eingeclipsten Leiterplattensteckverbinder sind kreuzweise Tragarme auf dem Rahmen angeformt, die vorzugsweise einen vergrößerten Kreuzungspunkt aufweisen, an dem eine Automatenmontage angreifen kann, um die Montagehilfe auf der Leiterplatte zu platzieren.
Es kann auch eine beliebige andere Konstruktion der Tragarme, z. B. in Form eines H's vorgesehen sein.

Zum zeitlichen Halten der Leiterplattensteckverbinder ist in dem Montagerahmen eine Haltevorrichtung angelehnt an das Feder-Nut-Prinzip vorgesehen.

Darüber hinaus kann die Steckseite der Leiterplattensteckverbinder mit einer Schutzvorrichtung in Form eines Deckels vorteilhaft gegen Verschmutzungen geschützt werden.

### Ausführungsbeispiel

Ein Ausführungsbeispiel der Erfindung ist in der Zeichnung dargestellt und wird im Folgenden näher erläutert. Es zeigen:
- Fig. 1: einen Montagerahmen für drei Leiterplattensteckverbinder,
- Fig. 2: einen mit drei Leiterplattensteckverbindern bestückten Montagerah- men,
- Fig. 3: eine Detailansicht auf den Montagerahmen mit eingefügten Leiterplat- tensteckverbindern,
- Fig. 4: eine Detailansicht auf eine Haltevorrichtung zwischen dem Montage- rahmen und einem Leiterplattensteckverbinder,
- Fig. 5: eine auf einer Leiterplatte aufgesetzte Montagehilfe mit darin vorgese- henen Leiterplattensteckverbindern,
- Fig. 6: eine Variante eines Montagerahmens zur Aufnahme von unterschied- lichen Leiterplattensteckverbindern, und
- Fig. 7: eine weitere Variante eines Montagerahmens mit integriertem Schutz- deckel.

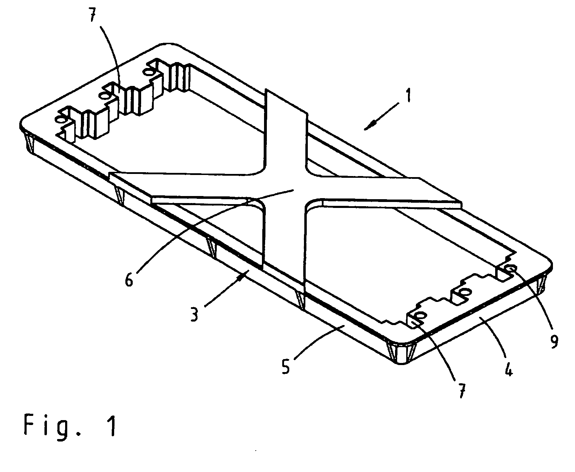

In der Fig.1 ist eine Montagehilfe 1 mit einem Montagerahmen 3 gezeigt, zur Aufnahme von mehreren Leiterplattensteckverbindern.
Der Montagerahmen 3 wird aus vier Rahmenstreben, zwei kürzeren Streben 4 und zwei längeren Streben 5 gebildet, wobei auf zwei der gegenüber angeordneten längeren Streben 5 sich kreuzende Tragarme 6 angeformt sind. In den hier kürzeren Streben 4 sind gegenüberliegende Ausnehmungen 7 vorgesehen, in denen jeweils Leiterplattensteckverbinder 15 einzusetzen sind, die auf einer Leiterplatte positioniert werden sollen.

Weiterhin sind Bohrungen 9 in den kürzeren Streben 4 angeordnet in die an den Leiterplattensteckverbindern 15 angeformte Führungsstifte 8 einfügbar sind.

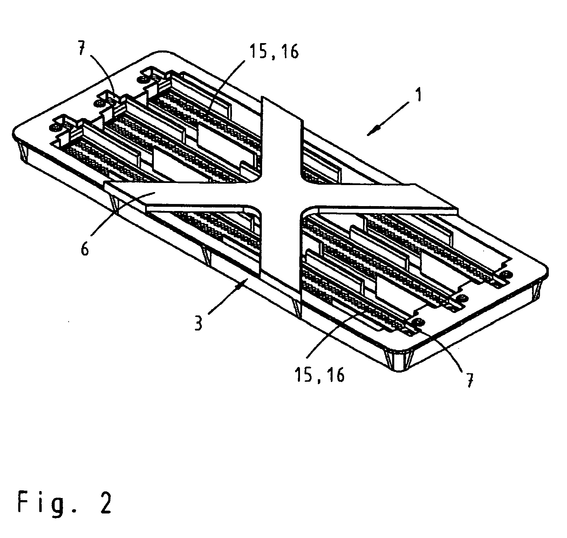

Die Fig. 2 zeigt einen entsprechend bestückten Montagerahmen 3 mit drei Leiterplattensteckverbindern 15.
Dabei werden die Leiterplattensteckverbinder derartig in die Ausnehmungen 7 im Montagerahmen 3 eingefügt, dass deren Steckseite 16 zur Kontaktierung mit einem entsprechenden Gegenstecker in Richtung der sich kreuzenden Tragarme 6 weisen.
Dazu werden die Leiterplattensteckverbinder 15 in den Ausnehmungen 7 eingeclippst, und die Montagehilfe 1 kann per Hand oder mit einer meist Vakuum betätigten Automatenhilfe auf einer Leiterplatte positioniert werden. Wobei die Toleranzen der Leiterplattensteckverbindern untereinander durch die Montagehilfe minimiert werden und der Rahmen eine gleichmäßige Ausrichtung der Leiterplattensteckverbinder auf der Leiterplatte bewirkt.

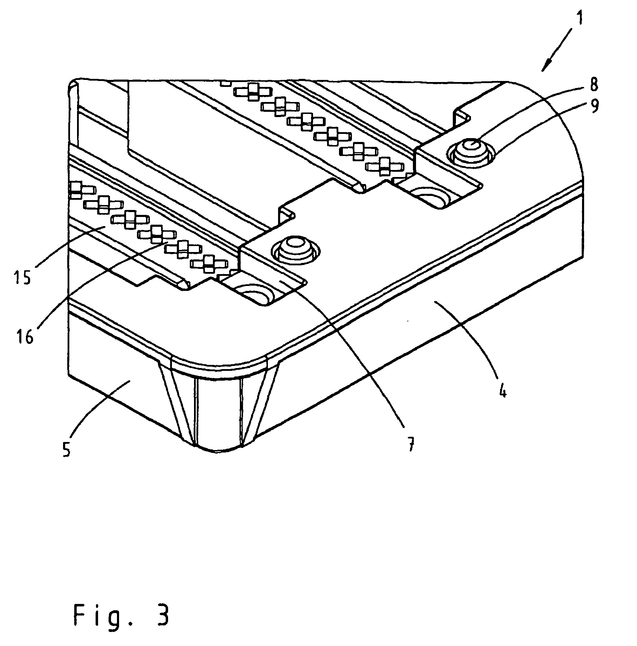

In der Fig. 3 ist in einer vergrößerten Detailansicht ein Blick auf die Steckseite 16 der Leiterplattensteckverbinder 15 in der Montagehilfe 1 gezeigt, wobei die Ausnehmungen 7 ersichtlich sind, in denen die Leiterplattensteckverbinder 15 gehalten werden, sowie die Führungstifte 8, die in den Bohrungen 9 stecken.

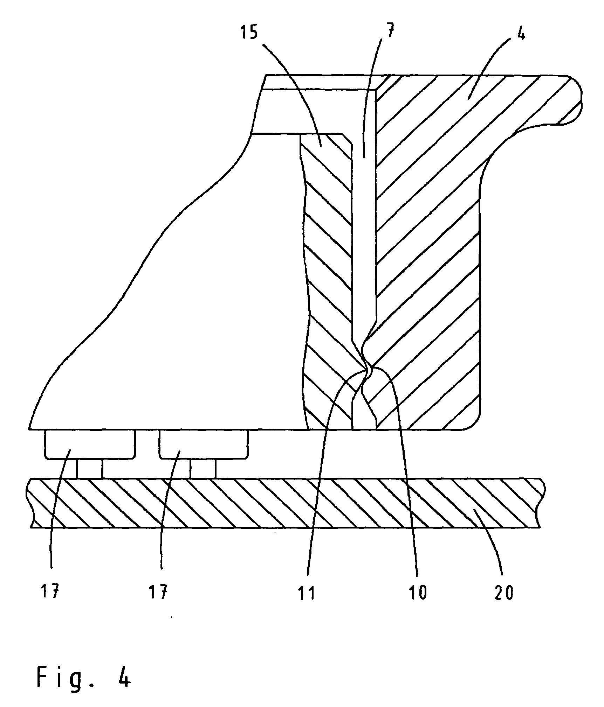

Die Haltevorrichtung zum Einclipsen ist in der Fig. 4 in einem Detail-Schnitt gezeigt, wobei das Ende des Leiterplattensteckverbinders 15 eine verrundete Rastnase 11 aufweist, die in eine stark verrundete Rastrille 10 im Montagerahmen 3 eingreift -jedoch nach dem Verlöten der Leiterplattensteckverbinder ein einfaches Lösen der Montagehilfe von den Steckverbindern erlaubt.

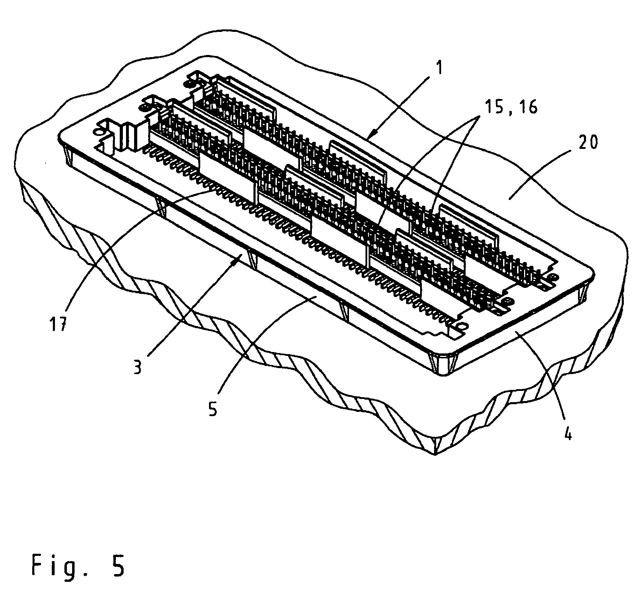

Die Fig. 5 zeigt die Montage von zwei Lefterplattensteckverbindern 15 in der Montagehilfe 1 auf einer Leiterplatte 20, wobei die Leiterplattensteckverbinder mit der Steckseite 16 hier nach oben weisen und die SMD-Anschlusskontakte 17 auf die Lötseite zeigen.

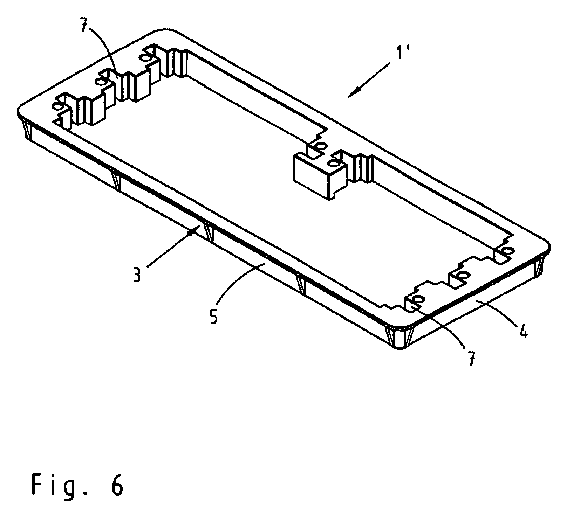

Für spezielle Anwendungen ist eine Variante einer Montagehilfe 1' vorgesehen bei der Leiterplattensteckverbinder mit unterschiedlichen Abmaßen auf einer Leiterplatte zu platzieren sind. Ein derartiger Rahmen 3 ist in der Fig. 6 gezeigt.

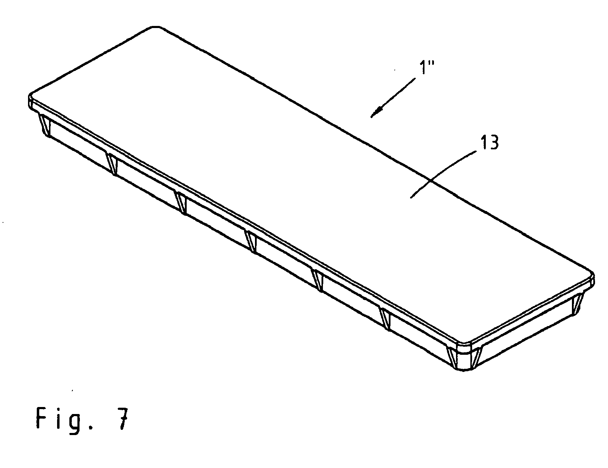

Falls für den Transport oder ein Schutz wie zum Beispiel beim Lötvorgang erforderlich ist, wird eine weitere Variante einer Montagehilfe 1" vorgeschfagen, bei der auf dem Montagerahmen ein Deckel 13 aufrastbar ist oder der Deckel ist fest mit Montagerahmen verbunden ist, wie in der Fig. 7 gezeigt.

### Bezugszeichenliste

### Montagehilfe

- 1: Montagehilfe
- 1': Montagehilfe: Variante für unterschiedliche Steckverbinder
- 1": Montagehilfe: Variante mit Schutzdeckel

- 3: Montagerahmen
- 4: kurze Streben
- 5: lange Streben
- 6: kreuzende Tragarme
- 7: Ausnehmungen für Steckverbinder
- 8: Führungsstifte
- 9: Bohrungen für Stifte 8
- 10: Rastrille im Rahmen
- 11: Rastnase, verrundet

- 13: Deckel

- 15: Leiterplattensteckverbinder
- 16: Steckseite
- 17: SMD-Lötseite

- 20: Leiterplatte

## Patentansprüche

1. Montagehilfe (1) für Leiterplattensteckverbinder zur Aufnahme und Aneinanderreihung von mindestens einem auf einer Leiterkarte zu positionierenden Leiterplattensteckverbinder (15), **dadurch gekennzeichnet,**
**dass** die Montagehilfe (1) einen umlaufenden, rechteckigen Montagerahmen (3) aufweist, bei dem auf zumindest zwei gegenüberliegenden Seiten (5) des Montagerahmens (3) sich kreuzende Tragarme (6) angeformt sind, und
**dass** in zwei weiteren gegenüberliegenden Seiten (4) des Montagerahmens Vorrichtungen zur mindestens zeitweisen Halterung der Leiterplattensteckverbinder (15) vorgesehen sind.

2. Montagehilfe nach Anspruch 1, **dadurch gekennzeichnet,**
**dass** die Vorrichtung zur Halterung der Leiterplattensteckverbinder (15) in gegenüberliegenden Ausnehmungen (7) im Montagerahmen (3) vorgesehen ist und entsprechend der Form der Leiterplattensteckverbinder (15) ausgeführt ist.

3. Montagehilfe nach Anspruch 2, **dadurch gekennzeichnet,**
**dass** die Vorrichtung zur Halterung als nut- und federähnliche Verbindung zum zeitweisen Verrasten der Leiterplattensteckverbinder (15) in der Haltevorrichtung vorgesehen ist, wobei die Nut als Rastrille (10) im Montagerahmen (3) geformt ist und die Feder als verrundete Rastnase (11) am Ende des Leiterplattensteckverbinders angeformt ist.

4. Montagehilfe nach Anspruch 1, **dadurch gekennzeichnet,**
**dass** in einer Variante in dem Montagerahmen (1') Leiterplattensteckverbinder (15) unterschiedlicher Abmaße positionierbar sind.

5. Montagehilfe nach Anspruch 1, **dadurch gekennzeichnet**,
das der Montagerahmen (1) einen verrastbaren Schutzdeckel (13) aufweist.

6. Montagehilfe nach Anspruch 1, **dadurch gekennzeichnet,**
**dass** in einer weiteren Variante der Montagerahmen (1 ") einen integrierten Schutzdeckel (13) aufweist.

## Claims

1. A mounting aid (1) for circuit board plug connectors for receiving and placing in line at least one circuit board plug connector (15) to be positioned on a circuit card, **characterized in that**
the mounting aid (1) includes a circumferential rectangular mounting frame (3) which has intersecting support arms (6) integrally molded on at least two opposite sides (5) of the mounting frame (3), and
that devices for at least temporarily retaining the circuit board plug connectors (15) are provided in two further opposite sides (4) of the mounting frame.

2. The mounting aid according to claim 1, **characterized in that** the device for retaining the circuit board plug connectors (15) is provided in oppositely located recesses (7) in the mounting frame (3) and is configured to correspond to the shape of the circuit board plug connectors (15).

3. The mounting aid according to claim 2, **characterized in that** the device for retaining is provided as a tongue and groove-like connection for temporarily locking the circuit board plug connectors (15) in the holding device, the groove being shaped as a locking flute (10) in the mounting frame (3) and the tongue being integrally molded as a rounded locking nose (11) on the end of the circuit board plug connector.

4. The mounting aid according to claim 1, **characterized in that** in one variant, circuit board plug connectors (15) of different dimensions can be positioned in the mounting frame (1').

5. The mounting aid according to claim 1, **characterized in that** the mounting frame (1) includes a lockable protective cover (13).

6. The mounting aid according to claim 1, **characterized in that** in a further variant, the mounting frame (1") includes an integrated protective cover (13).

## Revendications

1. Aide au montage (1) pour connecteurs à fiches pour plaque de circuit imprimé pour la réception et l'alignement d'au moins un connecteur à fiches (15) pour plaque de circuit imprimé à positionner sur une carte de circuit imprimé, **caractérisée en ce que**
l'aide au montage (1) présente un cadre de montage (3) circonférentiel et rectangulaire sur lequel sont conformés des bras de support (6) se croisant sur au moins deux côtés opposés (5) du cadre de montage (3), et
**en ce qu'**il est prévu des dispositifs dans deux autres côtés opposés (4) du cadre de montage pour retenir au moins temporairement les connecteurs à fiches (15) pour plaque de circuit imprimé.

2. Aide au montage selon la revendication 1, **caractérisée en ce que**
le dispositif pour la retenue des connecteurs à fiches (15) pour plaque de circuit imprimé est prévu dans des creux opposés (7) dans le cadre de montage (3) et est réalisé selon la forme des connecteurs à fiches (15) pour plaque de circuit imprimé.

3. Aide au montage selon la revendication 2, **caractérisée en ce que**
le dispositif pour la retenue est prévu sous forme de connexion à la manière d'une languette et d'une rainure pour l'enclenchement temporaire des connecteurs à fiches (15) pour plaque de circuit imprimé dans le dispositif de retenue, la rainure étant réalisée sous forme de gorge d'enclenchement (10) dans le cadre de montage (3), et la languette étant conformée sous forme d'ergot d'enclenchement (11) arrondi à l'extrémité du connecteur à fiches pour plaque de circuit imprimé.

4. Aide au montage selon la revendication 1, **caractérisée en ce que**
dans une variante, des connecteurs à fiches (15) de dimensions différentes sont aptes à être positionnés dans le cadre de montage (1').

5. Aide au montage selon la revendication 1, **caractérisée en ce que**
le cadre de montage (1) présente un couvercle de protection (13) apte à s'enclencher.

6. Aide au montage selon la revendication 1, **caractérisée en ce que**
dans une autre variante, le cadre de montage (1 ") présente un couvercle de protection (13) intégré.
